Europäisches Patentamt

European Patent Office

Office européen des brevets

(19)

(11) Veröffentlichungsnummer : **0 389 666 B1**

## (12) EUROPÄISCHE PATENTSCHRIFT

(45) Veröffentlichungstag der Patentschrift :
**07.12.94 Patentblatt 94/49**

(51) Int. Cl.$^5$ : **G01R 33/38**, G01R 33/56

(21) Anmeldenummer : **89107272.0**

(22) Anmeldetag : **21.04.89**

(54) **Anordnung zum Herstellen von Schnittbildern mit einem Kernspintomographen und Verfahren zum Betrieb der Anordnung.**

(30) Priorität : **28.03.89 DE 3910058**

(43) Veröffentlichungstag der Anmeldung :
**03.10.90 Patentblatt 90/40**

(45) Bekanntmachung des Hinweises auf die
Patenterteilung :
**07.12.94 Patentblatt 94/49**

(84) Benannte Vertragsstaaten :
**DE GB**

(56) Entgegenhaltungen :
**WO-A-85/04258
DE-A- 3 415 041
DE-A- 3 643 577
DE-A- 3 808 995**

(56) Entgegenhaltungen :
**SOCIETY OF MAGNETIC RESONANCE IN MEDICINE, SEVENTH ANNUAL MEETING AND EXHIBITION, 20-26 August 1988, San Francisco, CA, US ; J.H. KIM et al. : "Whole body NMR spiral-scan echo planar imaging (SEPI) using resonant gradient coil", Seite 1013.
JOURNAL OF PHYSICS E: SCIENTIFIC INSTRUMENTS, Band 11, 1978, London, GB; J.M.S.HUTCHISON et al.: "NMR imaging: image recovery under magnetic fields with large non-uniformities", Seiten 217-221
JOURNAL OP PHYSICS E. SCIENTIFIC INSTRUMENTS, Band 15, 1982, London, GB; G.JOHNSON et al.: "Instrumentation for NMR spin-warp imaging", Seiten 74-79**

(73) Patentinhaber : **SIEMENS AKTIENGESELLSCHAFT
Wittelsbacherplatz 2
D-80333 München (DE)**

(72) Erfinder : **Siebold, Horst, Dr.
Reuthlehenstrasse 63
D-8520 Erlangen (DE)**
Erfinder : **Frie, Wolfgang, Dr.
Auwiesenstrasse 1
D-8520 Erlangen (DE)**

EP 0 389 666 B1

Jouve, 18, rue Saint-Denis, 75001 PARIS

## Beschreibung

Die Erfindung bezieht sich auf eine Anordnung zum Herstellen von Schnittbildern mit einem Kernspintomographen nach dem Echo-Planar-Imaging-Verfahren EPI, bei dem der zeitliche Verlauf des Auslesegradienten einer cos-Funktion folgt. Der Kernspintomograph enthält Gradientenspulen, von denen einer mindestens ein Kondensator mit der Kapazität C zugeordnet ist, der mit der Induktivität L der Gradientenspule einen Serienresonanzkreis bildet, welcher mit einem Verstärker verbunden ist, der mit einer vorbestimmten Zeitfunktion $I_v(t)$ gesteuert wird. Ein entsprechender Resonanzkreis ist aus "Soc. of Magn. Reson. in Medicine", 7th Ann. Meet., San Francisco (USA), Aug. 20-26, 1988, Book of Abstracts, Vol. 2, Seite 1013 zu entnehmen.

Es sind Geräte zum Erzeugen von Schnittbildern eines Untersuchungsobjekts, vorzugsweise eines menschlichen Körpers, bekannt, deren Wirkungsweise auf magnetischer Kernresonanz beruht. Diese sogenannten Kernspintomographen enthalten einen Grundfeldmagneten, der die Kernspins im menschlichen Körper ausrichtet, und ferner ein Hochfrequenzsystem zur Anregung der Kernspins und zum Empfang der von den angeregten Kernspins emittierten Signale. Für die Schichtselektion und die räumliche Zuordnung der Signale in der Schicht sind ferner Gradientenspulen erforderlich, die ein in Richtung des Grundfeldes verlaufendes und sich in dieser Richtung linear änderndes Magnetfeld erzeugen. Weitere Gradientenspulen erzeugen ebenfalls ein in Richtung des Grundfeldes verlaufendes Magnetfeld, das sich jedoch in zwei dazu senkrechten Richtungen ändert. Durch Erregung dieser Gradientenspulen wird die Phase des im Anschluß an die Erzeugung des Grundfeldes in dem Hochfrequenzsystem induzierten Signals in Abhängigkeit von der Kernspinverteilung in dem untersuchten Körperbereich beeinflußt, so daß es möglich ist, aus der Kernspinverteilung ein Bild einer Schnittebene des Körpers abzuleiten.

Beim Einsatz der Gradientenspulen in einem Kernspintomographen für schnelle Pulsfolgen steigt der Anteil der höheren Audiofrequenzen von etwa 1 bis 10 kHz an, der im Spektrum der Pulsfolgen enthalten ist. Um sowohl einen erhöhten Leistungsbedarf als auch Feldverzerrungen in diesem Bereich aufgrund des Skin-Effekts in massiven Leitern zu vermeiden, können für die Windungen der Gradientenspulen Litzen- oder Seilleiter verwendet werden. Die Einzelsättel eines Spulensatzes der Gradientenspulen für eine vorbestimmte Raumkoordinate müssen auf möglichst kurzen Wegen und induktivitätsarm miteinander verbunden werden. Die jeweils einem der Feldgradienten $G_x$ oder $G_y$ zugeordneten Gradientenspulen, die im allgemeinen als Sattelspulen ausgebildet sind, können deshalb vorzugsweise jeweils aus einem einzigen Seilleiter bestehen. In einer besonderen Ausführungsform können diese Gradientenspulen als Sattelspulen ausgebildet sein, die aus drei Teilspulen besteht, die in der gleichen Zylinderfläche eines Trägerkörpers angeordnet sind. Die Windungszahlen der äußeren Teilspule zur mittleren Teilspule und zur inneren Teilspule können dabei in einem vorbestimmten Verhältnis, insbesondere etwa 1:1:4, zunehmen.

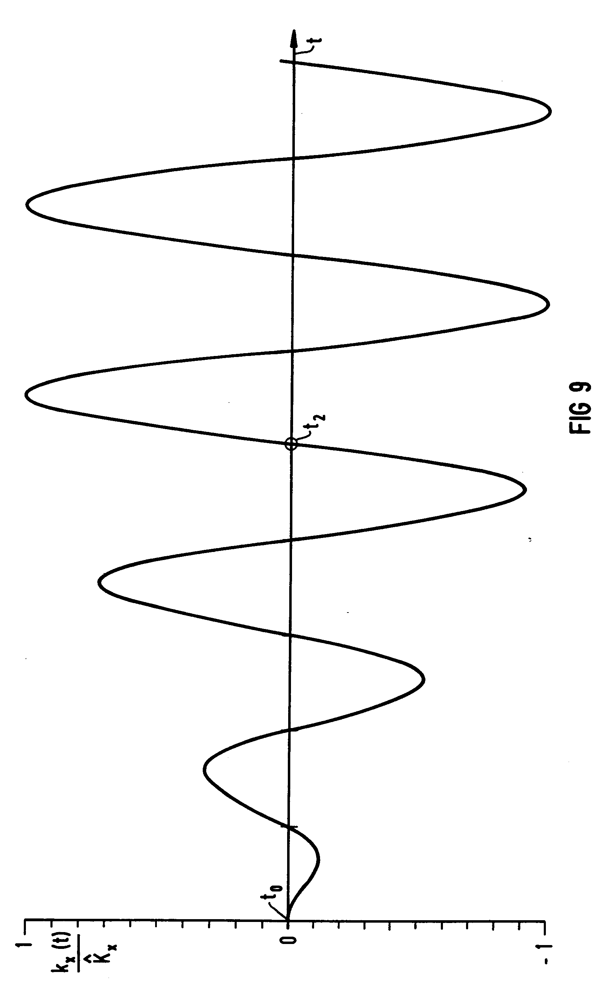

Zum Erzeugen von Schnittbildern in einem Kernspintomographen nach dem Echo-Planar-Verfahren EPI (echo-planar-imaging) wird das Bild aus Bildpunkten in der Schnittebene zusammengesetzt. Die Meßwerte werden in der Fourierebene erfaßt, d.h. gemessen wird die Fouriertransformation des Bildinhaltes. Durch zweimalige Fouriertransformation in zueinander senkrechten Richtungen, der x- und y-Richtung, werden aus den Meßdaten in der Wellenzahlebene die Bildwerte im Ortsraum errechnet. Die Auswahl der Körperschnittebene erfolgt durch selektive Schichtanregung mit einem Schnittselektionsgradienten und gleichzeitige Einstrahlung der Hochfrequenanregung. Die gesamte Information für ein Bild kann mit einer einzigen Elementarpulsfolge erfaßt werden. Im Auslesebereich ist der Phasenkodiergradient konstant, während der Auslesegradient oszilliert. Bei diesem bekannten Verfahren ist die gewünschte Wellenzahl ein Sinus, während der zugehörige Auslesegradient nach einer Cosinusfunktion verläuft. Am Anfang des Echotrain, der durch den Phasenkodiergradienten bestimmt wird, springt der Auslesegradient von Null auf seine maximale Amplitude (Journal of Magnetic Resonance 29 (1978), Seiten 355-373, insbesondere Figur 9).

Der Erfindung liegt nun die Aufgabe zugrunde, dieses bekannte Verfahren zum Herstellen von Schnittbildern durch magnetische Kernresonanz nach dem EPI-Verfahren zu vereinfachen und zu verbessern. Sie beruht auf der Erkenntnis, daß die Gradientenspule am Anfang des Meßbereiches $\tau_2$, in dem die Auslesung der Meßwerte erfolgt, nicht in der Form einer Sprungfunktion geschaltet werden kann.

Es ist ferner eine Anordnung zum Herstellen von Schnittbildern mit einem Kernspintomographen bekannt, der Gradientenspulen enthält, von denen eine mit einer Kapazität einen Parallelschwingkreis bildet. Zur Aufladung der Kapazität sind Verstärker vorgesehen. Zur Modulation des Gradientenfeldes ist ein Thyristorschalter vorgesehen, der zwischen der Gradientenspule und dem Kondensator angeordnet ist und die Schwingung in beiden Richtungen steuert. 180°-Hochfrequenzpulse dienen zur Anregung von Echo-Signalen. Der Strom im Resonanzkreis ist proportional dem Gradientenfeld. Der Strom in der Gradientenspule ist jedoch um den Gütefaktor Q größer als der Strom des Verstärkers. Diese Güte kann durch Wirbelströme und durch Temperaturänderung beeinflußt werden und ist somit während des Betriebes nicht konstant. Außerdem erfordert der die Schwingung steuernde Thyristorschalter einen verhältnismäßig großen Aufwand (US-PS 4 628 264).

Bei der aus der eingangs genannten Veröffentlichung aus "SMRM" zu entnehmenden Anordnung zur Ganzkörper-Kernspintomographie nach dem EPI-Verfahren ist für die Gradienten in x- und y-Richtung jeweils ein Serienresonanzkreis mit einer Gradientenspule der Induktivität L und einem Kondensator der Kapazität C vorgesehen. Der Resonanzkreis wird über einen Verstärker angesteuert, der einen Gradientenstrom liefert. Der zeitliche Verlauf der Gradientenfeldstärken $G_x$ und $G_y$ entspricht einem spiralförmigen Abtasten der $k_x$-$k_y$-Wellenzahlebene (SEPI).

Die Erfindung besteht deshalb in einer Anordnung gemäß dem Anspruch 1 und einem Verfahren zum Betrieb dieser Anordnung gemäß dem Anspruch 5. Durch den Serienschwingkreis zur Stromversorgung der Gradientenspule in Verbindung mit einem Regelverstärker kann der Auslesegradient so gesteuert werden, daß der Strom im Einschwingbereich $\tau_1$ und zu Beginn des Meßbereiches $\tau_2$ stetig ist und daß am Ende des Einschwingbereichs die Wellenzahl $k_x$ gerade null ist. In dieser ausführungsform eines Kernspintomographen mit einem Serienschwingkreis für die Gradientenspule werden die induktiven Spannungen an der Spule, die in der Größenordnung von einigen kV liegen, im Resonanzbetrieb des Schwingkreises durch die Kapazitäten kompensiert. Der Regelverstärker hat im eingeschwungenen Zustand nur den ohmschen Spannungsabfall aufzubringen.

Die Gradientenstärke des Auslesegradienten $G_x$ wird in jedem Zeitpunkt durch den Regelverstärker kontrolliert. Dies gilt insbesondere für den hier kritischen Einschwingbereich $\tau_1$. Dabei muß zunächst die Blindenergie der kapazitiven und induktiven Speicher vom Regelverstärker geliefert werden. Dem cosförmigen Verlauf des Auslesegradienten $G_x(t)$ wird somit der Einschwingvorgang im Einschwingbereich $\tau_1$ vorgeschaltet, in dem noch kein NMR-Signal gemessen wird. Dieser Einschwingbereich $\tau_1$ wird zeitlich begrenzt, damit das NMR-Signal nicht wesentlich geschwächt wird durch transversale Relaxation und durch Inhomogenitäten des magnetischen Grundfeldes.

Besonders vorteilhafte weitere Ausgestaltungen des Kernspintomographen gemäß der Erfindung ergeben sich aus den Unteransprüchen.

Zur weiteren Erläuterung der Erfindung wird auf die Zeichnung Bezug genommen, in deren Figur 1 der Aufbau eines Kernspintomographen als Blockschaltbild schematisch veranschaulicht ist. In den Figuren 2 und 3 ist jeweils ein Diagramm zur Erfassung der NMR-Signale in der Wellenzahlebene schematisch dargestellt. Figur 4 zeigt die Stromversorgung der Gradientenspule für den Auslesegradienten mit einem Serienresonanzkreis. In Figur 5 ist der Verlauf des Schichtselektionsgradienten und in Figur 6 der Verlauf des Phasenkodiergradienten und in Figur 7 der Verlauf des Auslesegradienten jeweils in einem Diagramm veranschaulicht. Der gemessene Verlauf des Stromes $I(t)$, der Wellenzahl $k_x(t)$ der Spannung $U(t)$ und der Leistung $P(t)$ ergibt sich aus den Diagrammen der Figuren 8 bis 11.

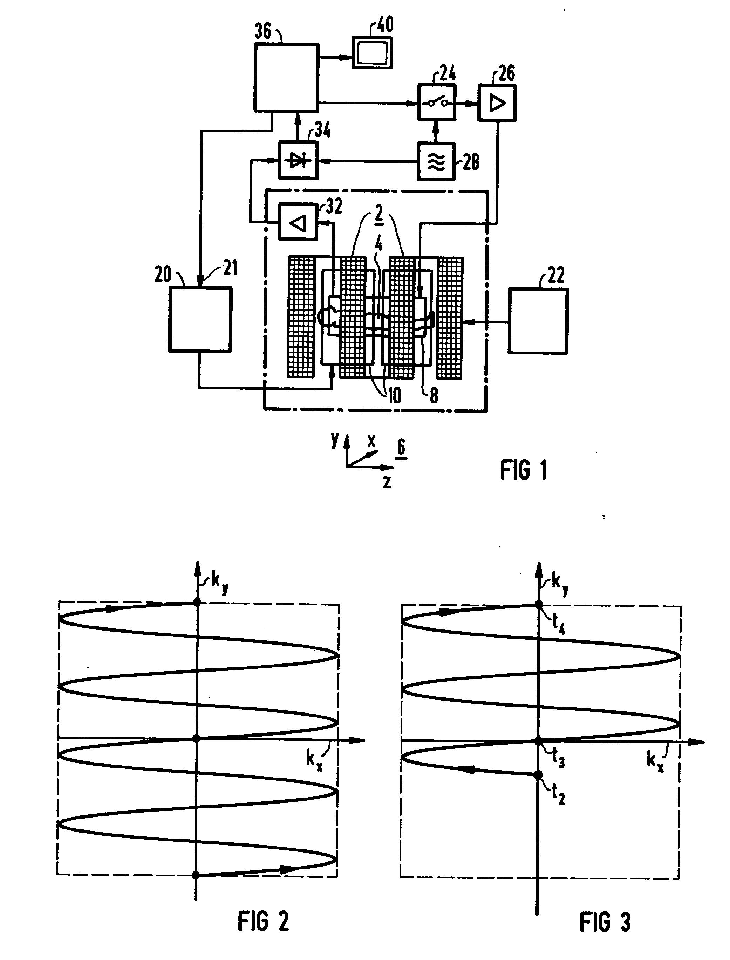

Im schematischen Blockschaltbild für einen Kernspintomographen gemäß Figur 1 sind eine magnetische Grundfeldspule mit 2, ein Untersuchungsobjekt, das vorzugsweise ein menschlicher Körper sein kann, mit 4, ein Koordinatensystem mit 6, eine Hochfrequenzspule mit 8 und eine Gradientenspule mit 10 bezeichnet. Diese Gradientenspule 10 kann beispielsweise aus wenigstens zwei nicht näher bezeichneten Teilspulen bestehen, die symmetrisch zur in der Figur ebenfalls nicht dargestellten Schnittebene angeordnet sind. Zur Stromversorgung der Gradientenspule 10 ist ein Regelverstärker 20 und zur Stromversorgung der Grundfeldspule 2 ein Netzgerät 22 vorgesehen.

Das Spulensystem der magnetischen Grundfeldspule 2, in die das Untersuchungsobjekt 4 eingeschoben ist, erzeugt ein magnetisches Grundfeld $B_O$ in Richtung der z-Achse eines Koordinatensystems 6. Zur Erzeugung unabhängiger, zueinander senkrechter Magnetfeldgradienten in den Richtungen x, y und z sind Gradientenspulen vorgesehen, von denen zur Vereinfachung nur das Spulensystem der Gradientenspule 10 dargestellt ist, die zur Erzeugung eines Auslesegradienten $G_x$ dienen soll. Die gleichartigen, nicht dargestellten Gradientenspulen für einen Phasenkodiergradienten $G_y$ liegen oberhalb und unterhalb des Untersuchungsobjekts 4 und die Gradientenspulen für einen Schichtselektionsgradienten $G_z$ liegen quer zum Untersuchungsobjekt 4 an seinem Kopf- und am Fußende. Die Anordnung enthält außerdem noch die zur Anregung der Kernresonanz und zur Aufnahme der NMR-Signale dienende Hochfrequenzspule 8, die über einen Sendeverstärker 26 und einen Modulator 24 angesteuert wird und deren Empfangssignale über einen Signalverstärker 32 sowie einen phasengesteuerten Gleichrichter 34 einem Computer 36 vorgegeben werden, dem ein Bildschirm 40 zugeordnet ist. Der Rechner 36 dient zugleich zur Steuerung der Gradientenspule 10 über den Regelverstärker 20 und zur Ansteuerung der Hochfrequenzspule 8 über den Modulator 24, dem auch das Signal eines Hochfrequenzoszillators 28 vorgegeben ist, der zugleich den Gleichrichter 34 steuert.

Nach der Einschaltung der Grundfeldspule 2 über das Netzgerät 22 und mit Hilfe der Gradientenstromversorgung über den Regelverstärker 20 sowie das Hochfrequenz-Sende- und Empfangssystem erfolgt zunächst die Anregung einer Schicht des Untersuchungsobjekts 4 bei z=const durch einen selektiven 90°-HF-Impuls. Dazu wird der Schichtselektionsgradient $G_z$ entsprechend einer vorbestimmten Zeitfunktion einge-

EP 0 389 666 B1

schaltet. Zugleich wird ein Hochfrequenzimpuls eingestrahlt, dessen Frequenz von der Lage der ausgewählten Schicht abhängig ist. Es folgen Gradientenstromimpulse für den Auslesegradienten $G_x$ und den Phasenkodiergradienten $G_y$. Im Meßbereich des Auslesegradienten $G_x$ entsteht ein Echo des Kernresonanzsignals, das mit Hilfe der Hochfrequenzelektronik abgetastet und ausgelesen wird. Ist ein vollständiger Datensatz erfaßt, so wird dieser im Rechner 36 einer zweidimensionalen Fourier-Transformation unterworfen und das entstandene Bild dem Bildschirm 40 übergeben und sichtbar gemacht.

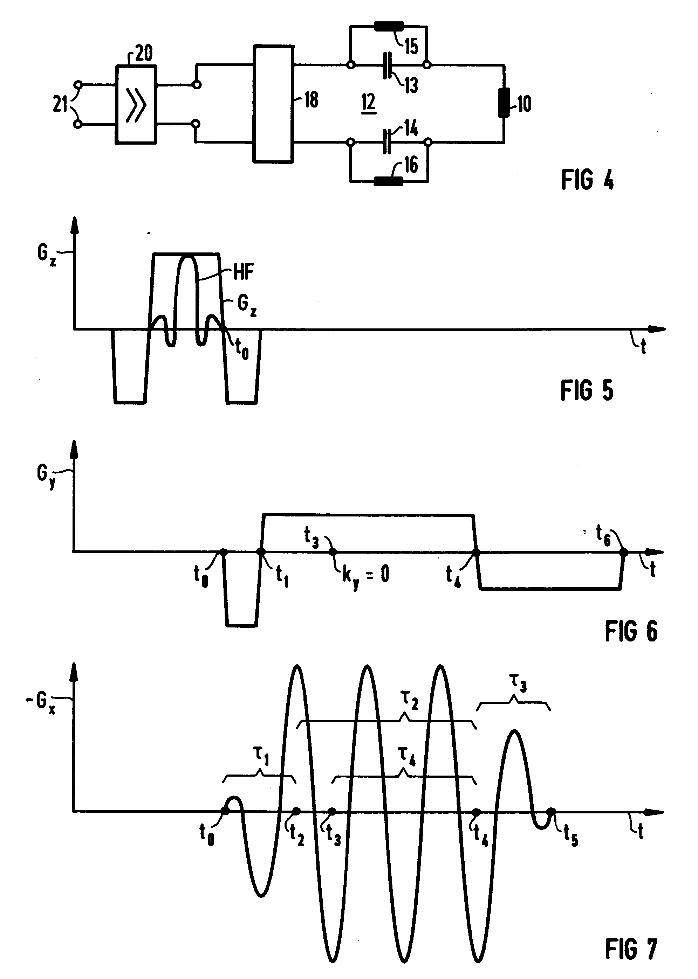

Die gesamte Bildinformation kann in nur einer Elementarpulsfolge, also nach nur einer Anregung der Kernspins, gewonnen werden. Hierzu muß die gesamte Wellenzahlebene [$k_x$, $k_y$] des realen Bildes in der durch den Schichtselektionsgradienten $G_z$ ausgewählten Schicht der x-y-Ebene mit z=0 durchlaufen werden, wie es im Diagramm der Figur 2 schematisch veranschaulicht ist. Wird das Signal phasenempfindlich gemessen, so genügt es im Prinzip, nur eine Hälfte der Wellenzahlebene mit Meßwerten abzudecken. In der Praxis wird jedoch gemäß dem schematischen Diagramm der Figur 3, in dem auf dem Lot die Wellenzahl $k_y$ und auf der Ordinate die Wellenzahl $k_x$ aufgetragen sind, ein Streifen um $k_y = 0$ herum mit beiden Vorzeichen von $k_x$ ausgemessen, um Information über den Phasengang der Hochfrequenzspule 8 mit zu gewinnen. Die dazu korrespondierende schematische Pulssequenz zeigen die Figuren 4 bis 7. Liegen Meßwerte auf einer sinusförmigen Bedeckung der Wellenzahlebene vor, so kann daraus auf eine kartesische äquidistante Bedeckung mit Meßpunkten interpoliert werden, und es kann die zweidimensionale Fourier-Transformation zum Ortsbild durchgeführt werden.

Mit den Wellenzahlen $k_x$ und $k_y$ lautet die gewünschte Wellenzahlfunktion:

$$k_y(t) = \dot{K}_y \cdot \frac{(t - t_3)}{\tilde{\tau}_4} \tag{1}$$

$$k_x(t) = \hat{K}_x \cdot \sin \omega (t - t_3), \tag{2}$$

wobei sich die Maximal-Wellenzahlen $\hat{K}_x$ und $K_y$ aus der gewünschten räumlichen Auflösung bzw. Pixel-Abmessung $\Delta x$, $\Delta y$ ergeben:

$$\hat{K}_x = \frac{\pi}{\Delta_x} \,;\, K_y = \frac{\pi}{\Delta y} \tag{3)(4}$$

Die Frequenz $\omega$ ergibt sich aus der Anzahl $N_y$ der gewünschten Bildzeilen. Da pro volle Sinus-Schwingung 2 Fourier-Zeilen gemessen werden, sind gemäß Figur 2 bei der Voll-Fourier-Variante $N_y/2$ volle Schwingungen und bei der Halb-Fourier-Variante nach Figur 3 etwas mehr als $N_y/4$ volle Schwingungen notwendig. Dies führt bei einem Meßbereich $\tau_2$, welcher der Belichtungszeit in der Fotografie entspricht, zu Frequenzen

$$\omega = 2\pi \cdot N_y / 2 \,\tau_4 \text{ bzw.} \tag{5}$$
$$\omega = 2\pi \cdot N_y / 4 \,\tau_4 \tag{6}$$

Die Wellenzahlen $k_x$, $k_y$ mit einer Kernspindichte $\rho(x, y)$ und einer Kernmagnetisierung $\vec{M}$ im rotierenden Bezugssystem

$$\vec{M}(x, y) \sim \rho(x, y) \, exp\{j k_x x\} exp\{j k_y y\} \tag{7}$$

lassen sich mit einer Wellenzahl $k_y$ erzeugen durch Gradientenfelder:

$$\gamma \cdot G_i(t) = \frac{\partial k_i}{\partial t} \tag{8}$$

beim EPI-Verfahren also:

$$G_y(t) = \gamma^{-1} \cdot \frac{K_y}{\tau_4} \tag{9}$$

$$G_x(t) = \gamma^{-1} \hat{K}_x \omega \cos \omega (t - t_3) \overset{def.}{=} \hat{G}_x \cos \omega (t - t_3) \tag{10}$$

Die Gradientenstärke $G_x(t)$ ist dem in den Gradientenspulen fließendem Strom $I_x(t)$ proportional:

4

$$G_x(t) = g \cdot J_x(t) \quad (11)$$

Darin ist g ein Faktor, der abhängt von der Geometrie und der Windungszahl der Spule. Als Amplitude erhält man somit:

$$\hat{G}_x = g \cdot \hat{J}_x \quad (12)$$

Für eine Pixelabmessung von beispielsweise $\Delta x = \Delta y = 2{,}4$ mm und einer Aufnahmezeit $\tau_2 = 51$ msec führen die obigen Gleichungen zu einer Betriebsfrequenz $\omega$ von $2\pi \cdot 1{,}25$ kHz und einer Gradientenamplitude von $\hat{G}_x = 40$ mT/m. Solche Werte sind mit den üblichen Spulen und Verstärkern der NMR-Anlagen nicht zu erreichen. Bei Spulen, die den Körper umschließen, um Aufnahmen des menschlichen Herzens zu gestatten, wären Anschlußleistungen von ca. 500 MW erforderlich.

Gemäß der Erfindung ist deshalb gemäß Figur 4 die Gradientenspule 10 für den Auslesegradienten $G_x$ über einen Serienschwingkreis aus einem der in der Figur nicht dargestellten Kondensator 12 mit der Kapazität C, der vorzugsweise aufgeteilt sein kann in Kondensatoren 13 und 14 mit jeweils der Kapazität 2 C, an einen Regelverstärker 20 angeschlossen, der als Stromregler betrieben wird. Der Regelverstärker 20 wird gemäß der Erfindung an seinem Steuereingang 21 vom Rechner 36 so gesteuert, daß der Stromverlauf im Einschwingbereich und zu Beginn des Meßbereichs stetig ist und die Wellenzahl $k_x$ am Anfang $t_2$ des Meßbereichs $\tau_2$ null ist. Als Regelverstärker 20 kann ein in der Kernspintomographie üblicher Leistungsverstärker PSU (power supply unit) für eine Spannung von einigen 100 V und einen Strom von einigen 100 A vorgesehen sein. Dieser Regelverstärker 20 liefert einen Gradientenstrom I für die Gradientenspule 10, der unabhängig ist vom Spulenwiderstand und auch unabhängig vom Verhältnis ihrer Induktivität zur reellen Last. In einer besonderen Ausführungsform der Anordnung kann als Regelverstärker 20 ein sogenannter Schaltregelverstärker vorgesehen sein. Zwischen der Gradientenspule 10 und dem Regelverstärker 20 kann vorzugsweise noch ein Tiefpaßfilter 18 vorgesehen sein, das tiefe Frequenzen, beispielsweise weniger als 10 kHz, durchläßt und hohe Frequenzen, beispielsweise höher als 1 MHz, sperrt. Dieses Tiefpaßfilter schirmt somit hochfrequente Einstrahlungen, die den Betrieb der Hochfrequenzspule 8 stören können, ab und läßt nur den Gradientenstrom I durch. In der dargestellten Ausführungsform mit aufgeteilten Kapazitäten teilt sich die Betriebsspannung von beispielsweise etwa 4 kV auf die beiden Kondensatoren 13 und 14 auf und bewirkt zugleich eine Spannungsverminderung an der Gradientenspule 10 gegen Masse. Die Gradientenspule 10 kann vorzugsweise aus einem einzigen Seilleiter bestehen. In dieser Ausführungsform erhält man bei höheren Frequenzen nur einen geringen Skin-Effekt und somit einen entsprechend geringen Widerstandsanstieg.

Eine besonders vorteilhafte Ausführungsform der Anordnung besteht darin, daß zur Kapazität 12 noch eine Drossel parallelgeschaltet wird. In der dargestellten Ausführungsform ist somit zu den Kondensatoren 13 und 14 jeweils eine Drossel 15 bzw. 16 parallelgeschaltet. Diese Drosseln 15 und 16 leiten den unvermeidlichen DC-Offset des Regelverstärkers 20 von beispielsweise etwa 0,5 mA auf dem Parallelweg an den Kondensatoren 13 und 14 vorbei, so daß diese durch den Fehlerstrom nicht aufgeladen werden können. Für den Betriebsstrom mit einer Frequenz von beispielsweise etwa 1 kHz bleiben die Drosseln 15 und 16 unwirksam. Der so entstandene Gleichstrompfad erlaubt es, einen vorbestimmten DC-Strom auch dem oszillierenden Auslesegradienten einzuprägen, um lineare Feldgradienten zu erzeugen, die Inhomogenitäten des Grundfeldes vom Typ 1. Ordnung kompensieren sollen.

Gemäß dem Diagramm der Figur 5, in dem der Schichtselektionsgradient $G_z$ über der Zeit t aufgetragen ist, wird zu einem beliebig wählbaren und in der Figur nicht bezeichneten Zeitpunkt ein Schichtselektionsgradient $G_z$ erzeugt. Zugleich wird mit einem Hochfrequenzpuls HF die Hochfrequenzspule 8 gespeist und damit eine Schicht angeregt. Zugleich wird gemäß Figur 6 zur Zeit $t_0$ ein Phasencodiergradient $G_y$ eingeschaltet, der den Meßbereich $\tau_2$ für die Datenerfassung vom Zeitpunkt $t_2$ bis $t_4$ bestimmt. Dem Meßbereich $\tau_2$ gemäß dem Diagramm der Figur 7, in dem der Auslesegradient $G_x$ über der Zeit t aufgetragen ist, wird nun gemäß der Erfindung ein Einschwingbereich $\tau_1$ von $t_0$ bis $t_2$ vorgeschaltet. Der Verlauf des Auslesegradienten $G_x$ im Einschwingbereich $\tau_1$ erfüllt die Forderung, daß der Gradientenstrom zu Beginn des Meßbereichs zur Zeit $t_2$ und auch im Einschwingbereich $\tau_1$ stetig sein muß, da der Gradientenstrom I nicht sprunghaft auf die maximale Amplitude zur Zeit $t_2$ ansteigen kann.

Im Einschwingbereich $\tau_1$ muß zunächst die Blindenergie der kapazitiven und induktiven Speicher vom Regelverstärker 20 geliefert werden. Dem cos-förmigen Verlauf des Auslesegradienten $G_x$ ist deshalb ein Einschwingvorgang für die Zeit $t_0$ bis $t_2$ vorgeschaltet, in dem noch kein NMR-Signal gemessen wird. Eine Pulsfolge für die Halb-Fourier-Variante gemäß Figur 3 hat dann den Verlauf, wie er in Figur 7 dargestellt ist.

Der Einschwingbereich $\tau_1$ wird kurz gehalten, damit das NMR-Signal nicht wesentlich geschwächt wird durch transversale Relaxation und durch Inhomogenitäten des Grundfeldes. Der Regelverstärker 20 ist gekennzeichnet durch seinen Maximalstrom $I_{max}$ und seine Maximalspannung $U_{max}$ an seinen Ausgangsklemmen, die beide nicht überschritten werden dürfen. Um seine Verstärkung möglichst gut auszunutzen, sollen nun die Spannungsspitzen $\hat{U}$ beim Einschwingen bis auf eine Regelreserve $\varepsilon \approx 0{,}1$ an $U_{max}$ heranreichen. Man erhält somit einen Verlauf der Ausgangsspannung

$$\mathcal{U}(t) = H(t) \cdot \hat{U} \, \sin\{\omega t + \rho_0\} \leq (1-\varepsilon) \, \mathcal{U}_{max} \qquad (13)$$

Darin ist H(t) die Heaviside-Sprungfunktion.

Außerdem muß der Stromverlauf I(t) stetig von I = 0 aus beginnen und zur Zeit $t_2$ auch stetig in den stationären (eingeschwungenen) Zustand mit der Amplitude $\hat{I}_x$ übergehen. Ferner sind nur solche Lösungen physikalisch brauchbar, bei denen zu diesem Zeitpunkt $t_2$, ab dem die Meßwerte erfaßt werden, die Wellenzahl $k_x$ gerade 0 ist. Es ist somit zu fordern:

$$k_x(t_2) = g \cdot \gamma \int_{t_0}^{t_2} J(t)\, dt \overset{!}{=} 0 \qquad (14)$$

Die optimale Einschwingfunktion I($t_0$ bis $t_2$), mit der der Regelverstärker 20 angesteuert werden muß, beispielsweise über in Figur 1 zur Vereinfachung nicht dargestellte DA-Wandler, lautet:

$$J(t_0 \leq t \leq t_2) = \omega_1^{-1} \hat{J}_x \Big\{ q_0 \cos \omega t' + a\,\omega \sin \omega t' \qquad (15)$$
$$+ e^{-\alpha t'} \Big[ a\,(-\alpha \cos \omega_1 t' - \omega_1 \sin \omega_1 t'$$
$$+ \quad b\,(\alpha \sin \omega_1 t' + \omega_1 \cos \omega_1 t' ] \Big\}$$

mit $t' = t - t_0$.

Dabei stellt sich ein Verlauf der Spannung U mit konstanter Einhüllung ein:

$$\mathcal{U}(t_0 \leq t \leq t_2) = \omega_1^{-1} \hat{J}_x C \Big\{ \sin \omega t' \Big[ \frac{q_0(1-\omega^2 LC) + a\,\omega^2 RC}{\omega} \Big] \qquad (16)$$
$$- \cos \omega t' \Big[ a(1-\omega^2 LC - q_0 RC] \Big\}$$

Die Gradientenfrequenz $\omega$ ist bekannt. Die Größen

R    Gesamtheit aller Widerstände im Schwingkreis,

C    Kapazität und

L    Induktivität der Gradientenspule werden gemessen. Daraus ergeben sich auch

$\alpha$    = R/(2 L) und

$\omega_1$    = (1/(LC) - $\alpha^2)^{1/2}$, die Resonanzfrequenz.

Die noch unbekannten Größen $q_0$, a, b ergeben sich allgemein aus folgenden Forderungen:

1) Am Anfang des Einschwingbereichs $\tau_1$ zur Zeit $t_0$ ist der Gradientenstrom null, d. h.

$$J(t_0) = 0 \rightarrow q_0 - \alpha a + \omega_1 b = 0 \qquad (17)$$

2) Am Ende des Einschwingbereichs $\tau_1$ zur Zeit $t_2$ muß die Wellenzahl $k_x$ null sein, d. h.

$$\int_{t_0}^{t_2} J(t)\, dt = 0$$

$$\longrightarrow \omega^{-1} q_0 \sin \omega \tau_1 + a\left\{-\cos \omega \tau_1 + e^{-\alpha \tau_1} \cos \omega_1 \tau_1\right\}$$

$$+ b \cdot e^{-\alpha \tau_1} \sin \omega_1 \tau_1 = 0 \tag{18}$$

3) Am Anfang des Meßbereichs $\tau_2$ zur Zeit $t_2$ muß der Gradientenstrom seinen Scheitelwert erreicht haben, d.h.

$$J(t_2) = \hat{J}_x$$

$$\longrightarrow q_0 \cos \omega \tau_1 + a\left\{\omega \sin \omega \tau_1 - e^{-\alpha \tau_1}\left[\alpha \cos \omega_1 \tau_1 + \omega_1 \sin \omega_1 \tau_1\right]\right\} \tag{19}$$

$$+ b \cdot e^{-\alpha \tau_1}\left[-\alpha \sin \omega_1 \tau_1 + \omega_1 \cos \omega_1 \tau_1\right] = \omega_1$$

Daraus ergeben sich die Lösungen

$$\alpha = \frac{\omega_1\left(\psi_1 - \dfrac{\Phi_1}{\omega}\right)}{N} \tag{22}$$

$$b = \frac{\psi_1 \alpha - \psi_2 + \Phi_2}{N} \tag{23}$$

$$q_0 = \frac{\omega_1\left(\psi_2 - \Phi_2 - \alpha \dfrac{\Phi_1}{\omega_1}\right)}{N} \tag{24}$$

mit folgenden Abkürzungen:

$$\psi_1 = \frac{\sin \omega \tau_1}{\omega}$$

$$\psi_2 = \cos \omega \tau_1$$

$$\phi_1 = e^{-\alpha \tau_1} \sin \omega_1 \tau_1$$

$$\phi_2 = e^{-\alpha \tau_1} \cos \omega_1 \tau_1 \tag{20}$$

und

$$N = \omega^2 \psi_1^2 - \psi_1 \Phi_1\left(\omega_1 + \frac{\alpha^2}{\omega_1} + \frac{\omega^2}{\omega_1}\right) + \Phi_1^2 + (\psi_2 - \Phi_2)^2 \tag{21}$$

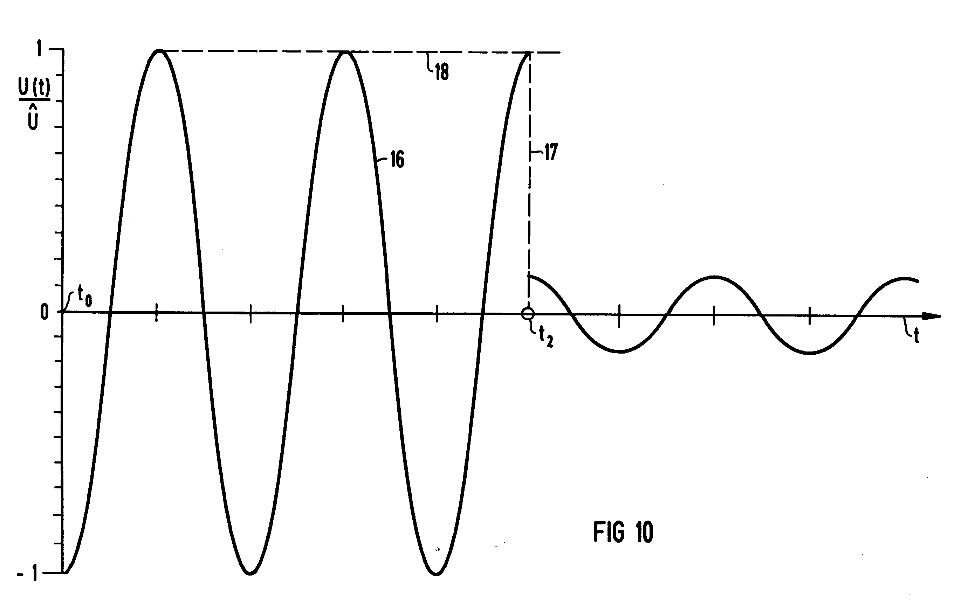

Die zugehörige Spitzenspannung $\hat{U}$ gemäß Figur 10 beträgt

$$\hat{u} = \frac{\hat{J}_x}{\omega_1 C}\left\{\left[(1 - \omega^2 LC)^2 + (\omega RC)^2\right] \cdot \left[\frac{q_0^2}{\omega^2} + a^2\right]\right\}^{\frac{1}{2}} \tag{25}$$

Man mißt zunächst die technischen Daten R, C, L und damit auch $\alpha$ und $\omega_1$. Man wählt die Dauer des Einschwingbereiches $\tau_1$ von $t_0$ bis $t_2$, vorzugsweise in Mehrfachen n der halben Schwingungsdauer:

7

$$\omega\,\tau_1 \approx n\pi \quad (26)$$

Da die technischen Daten mit Meßfehlern bzw. Drift behaftet sind, ist der Resonanzabgleich im allgemeinen nicht perfekt möglich, und es gilt nur annähernd:

$$\omega_1 \approx \omega$$

und

$$\omega_1\,\tau_1 \approx n\,\pi \quad (27)$$

Für den Sonderfall $\omega = \omega_1$, also bei exakter Abstimmung des Schwingkreises, vereinfachen sich die Lösungen für a, b, $q_o$ wesentlich. Dann werden nämlich

$$\psi_1 = 1 \,;\, \psi_2 = (-1)^n$$
$$\Phi_1 \approx 0 \,;\, \Phi_2 \approx (-1)^n.$$

Nach der Berechnung der Parameter a, b, $q_O$ für die gewählte Einschwingdauer prüft man, ob damit die Spitzenspannung $\hat{U}$ gemäß Figur 10 dem Verstärker abverlangt werden kann; andernfalls ist die Einschwingdauer $\tau_1$ entsprechend größer zu wählen.

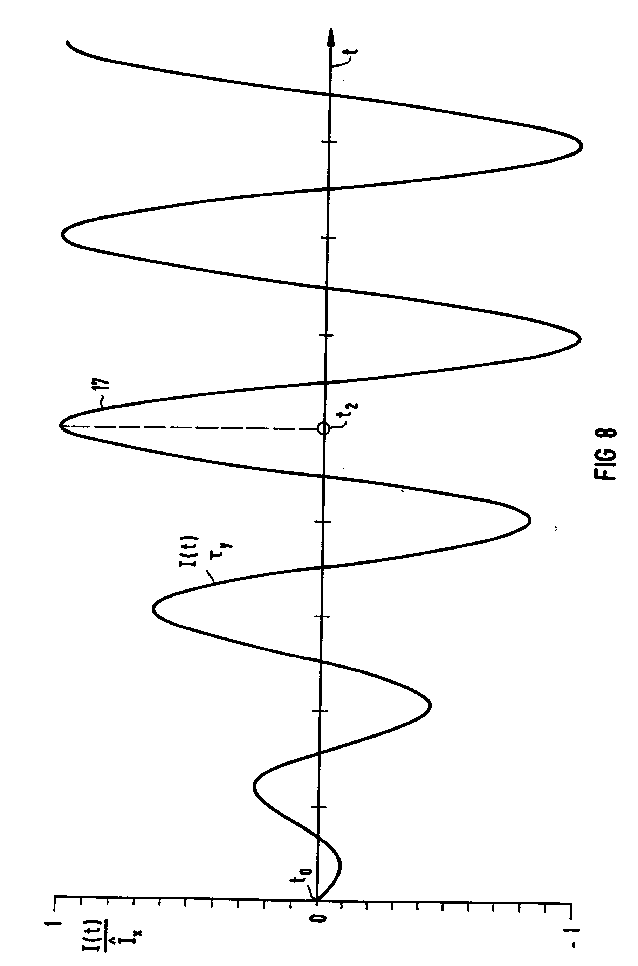

Der sich ergebende Verlauf des Stromes I ergibt sich aus dem Diagramm der Figur 8, in dem der Strom I, normiert auf die Amplitude $\hat{I}$, aufgetragen ist über der Zeit t. Im Einschwingbereich von $t_0$ bis $t_2$ steigt der Strom stetig und erreicht seine maximale Amplitude zur Zeit $t_2$ beim Beginn des Meßbereichs. Dieser Einschwingvorgang wird vom Rechner 36 berechnet, und am Ende des Einschwingbereiches zur Zeit $t_2$ wird die Erzeugung des Eingangssignals 21 umgeschaltet auf stationären Betrieb.

Der Verlauf der Wellenzahl $k_x$ als Funktion der Zeit t ist dargestellt im Diagramm der Figur 9, in dem die Wellenzahl $k_x$ normiert auf die Amplitude $\hat{K}_x$ über der Zeit t aufgetragen ist. Am Ende des Einschwingbereichs zur Zeit $t_2$ ist die Wellenzahl $k_x$ null.

Aus Figur 10, in der die Ausgangsspannung U des Regelverstärkers 20 normiert auf die Amplitude $\hat{U}$ über der Zeit t aufgetragen ist, ergibt sich der Verlauf der Spannung U. Die Spannungsamplitude $\hat{U}$ muß kleiner bleiben als die maximale Spannung des Verstärkers 20, damit eine Sättigung vermieden wird. Am Ende des Einschwingbereichs $\tau_1$ zur Zeit $t_2$ springt die Spannung zurück auf einen wesentlich geringeren, im Diagramm nicht besonders bezeichneten Wert, der den Spannungsbedarf des Stromkreises für ohm'sche Verluste deckt.

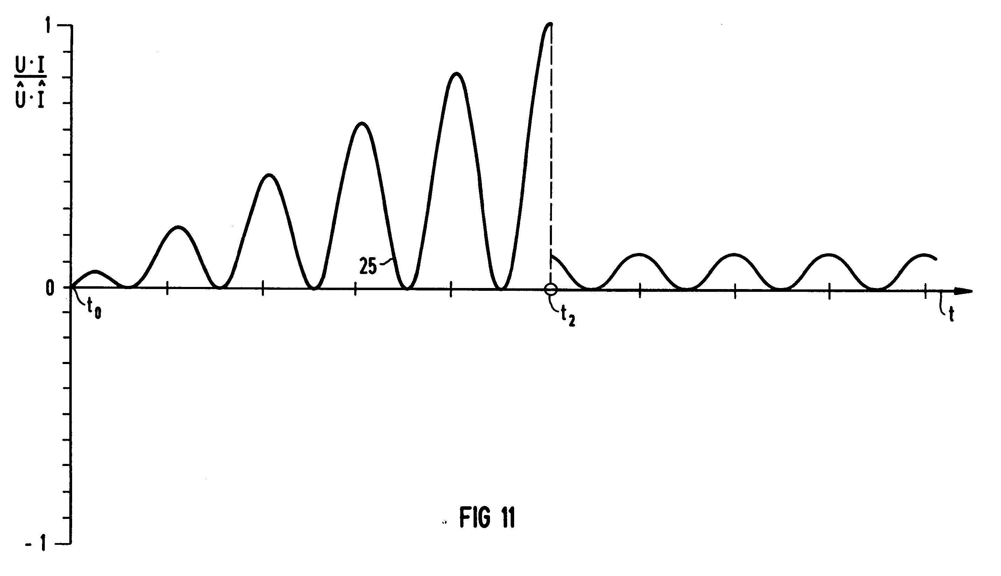

Aus dem Diagramm der Figur 11 erhält man den Verlauf der Leistung P(t) des Verstärkers 20 für einen Einschwingbereich $\tau_1$ von beispielsweise n = 5. Die Leistung P ist im wesentlichen positiv und besteht somit nur aus Wirkleistung. Bei nicht exakter Abstimmung der Resonanz entstehen auch negative, d.h. Blindleistungsanteile im Meßbereich $\tau_2$, die der Regelverstärker 20 verarbeiten muß.

Besonders vorteilhaft ist ein sogenannter Schaltregelverstärker einzusetzen. Dessen Schaltfrequenz $\omega_s$ muß allerdings wesentlich höher als die Gradientenfrequenz $\omega$ gewählt werden; der Serienschwingkreis ist dann induktiv für $\omega_s$ und fungiert als der notwendige induktive Energiespeicher.

Ungenauigkeiten beim Messen des Widerstandes R der Induktivität L und der Kapazität C bewirken nur, daß die auftretende Spitzenspannung $\hat{U}$ nicht genau bekannt ist. Dies wird durch die Regelreserve $\varepsilon$ ausgeglichen. Da der Verstärker 20 als Stromregler betrieben wird, entspricht der Gradientenstrom $I_x(t)$ präzise dem vom Rechner 36 beispielsweise über DA-Wandler eingespeisten Strom. Das in sich konsistent gelöste Gleichungssystem für die Größen a, b, $q_O$ stellt sicher, daß die geforderten Stetigkeits- und Randbedingungen, wie sie sich aus den Gleichungen 17, 18, 19 für I(t) ergeben, in allen Fällen erfüllt sind.

Da ein Serienschwingkreis keinen additiven, konstanten Gleichstromanteil zuläßt, der mit Hilfe der Gradientenspulen die linearen Feldgradienten zur Korrektur von Grundfeldinhomogenitäten erzeugt, können in einer bevorzugten Ausführungsform die Kondensatoren 13 und 14 jeweils durch die Drossel 15 bzw. 16 überbrückt werden. Deren Induktivität wird sehr groß gegen diejenige der Gradientenspulen gewählt. Sie stört deshalb nicht den Resonanzbetrieb, erlaubt aber nun, daß der Verstärker 20 einen Gleichstromanteil in die Gradientenspule 10 einspeisen kann.

Nach der stationären Cosinus-Schwingung des Auslesegradienten $G_x$ wird vorteilhaft auch das Ausschwingen in einem Ausschwingbereich $\tau_3$ von $t_4$ bis $t_5$ gemäß Figur 7 stromkontrolliert, obwohl die Erfassung der Meßwerte am Ende des Meßbereichs $\tau_2$ zur Zeit $t_3$ bereits abgeschlossen ist. Es entstehen dann keine gefährlichen Spannungsspitzen.

Wählt man den Verlauf im Ausschwingbereich $\tau_3$ von $t_4$ bis $t_5$ zeitgespiegelt:

$$J\,(t - t_4) = \pm\,J\,(t_2 - t),$$

so ist

$$\int_{t_c}^{T_{rep}} G_x(t)\,dt = 0$$

sichergestellt, wobei $T_{rep}$ der Zeitpunkt des Beginns des nächsten Schichtbildes ist.

Ferner kann, wie in den Figuren 5 und 6 dargestellt ist, auch der Verlauf des Schichtselektionsgradienten $G_z(t)$ und des Phasenkodiergradienten $G_y(t)$ so gestaltet werden, daß nach Abschluß der gesamten Pulssequenz alle Gradientenintegrale = 0 sind. Dies minimiert die schädlichen Einflüsse von Wirbelströmen in elektrisch leitenden Spulen- und Magnetstrukturen.

Die Rolle der x, y, z-Gradientenspulen kann auch vertauscht werden, um eine andere Schnittebene als die hier gewählte z-Ebene zu erhalten.

## Patentansprüche

1. Anordnung zum Herstellen von Schnittbildern mit einem Kernspintomographen nach dem Echo-Planar-Verfahren EPI mit Gradientenspulen, von denen einer mindestens ein Kondensator mit der Kapazität C zugeordnet ist, der mit der Induktivität L der Gradientenspule einen Serienresonanzkreis bildet, welcher mit einem Verstärker verbunden ist, der mit einer vorbestimmten Zeitfunktion $I_v(t)$ gesteuert wird, **gekennzeichnet** durch folgende Merkmale:
   a) Es sind Mittel vorgesehen, die den Strom (I) durch die Gradientenspule (10) mit dem mindestens einen Kondensator (12; 13, 14) so steuern,
   daß
   - in einem Meßbereich $\tau_2$ ($t_2$ bis $t_4$) der Auslesegradient $G_x$ einen cosinusförmigen Verlauf zeigt und daß
   - in einem dem Meßbereich $\tau_2$ unmittelbar vorangehenden Einschwingbereich $\tau_1$ ($t_0$ bis $t_2$) und auch zu Beginn des Meßbereichs der Gradientenstrom (I) stetig ist, wobei am Ende ($t_2$) des Einschwingbereichs $\tau_1$ die durch das Zeitintegral des Auslesegradienten $G_x$ gegebene Wellenzahl $k_x$ gerade null ist,
   b) der mit dem Resonanzkreis verbundene Verstärker ist ein den unter Merkmal a) aufgeführten Mitteln zugeordneter Regelverstärker (20), der als Stromregler betrieben wird.

2. Anordnung nach Anspruch 1, **dadurch gekennzeichnet**, daß die Kapazität C des Kondensators (12) aufgeteilt ist in zwei Teilkapazitäten 2 C von zwei Kondensatoren (13, 14), die symmetrisch zur Gradientenspule (10) angeordnet sind.

3. Anordnung nach Anspruch 2, **dadurch gekennzeichnet**, daß den Teilkapazitäten jeweils eine Drossel (15 bzw. 16) parallelgeschaltet ist.

4. Anordnung nach Anspruch 1, **dadurch gekennzeichnet**, daß als Regelverstärker ein Schaltregelverstärker vorgesehen ist.

5. Verfahren zum Betrieb einer Anordnung nach Anspruch 1, **gekennzeichnet** durch einen stromgeregelten Betrieb des Resonanzkreises derart, daß dem cosinusförmigen Verlauf des Auslesegradienten $G_x$ im Meßbereich $\tau_2$ ($t_2$ bis $t_4$) ein gesteuerter Einschwingbereich $\tau_1$ ($t_0$ bis $t_2$) vorgeschaltet wird, in dem der Gradientenstrom (I) stetig ist und an dessen Ende ($t_2$) die Wellenzahl $k_x$ null ist.

6. Verfahren nach Anspruch 5, **gekennzeichnet** durch eine Steuerung am Eingang (21) des Regelverstärkers (20) derart, daß der Stromverlauf im Einschwingbereich $\tau_1$ ($t_0$ bis $t_2$) gegeben ist durch

$$J\,(t_0 \le t \le t_2) = \omega_1^{-1}\,\hat{J}_x\,\{q_0\cos\omega t' + a\,\omega\sin\omega t'$$
$$+\,e^{-\alpha t'}\,[\,a(-\alpha\cos\omega_1 t' - \omega_1\sin\omega_1 t'$$
$$+\quad b\,(\alpha\sin\omega_1 t' + \omega_1\cos\omega_1 t')]\}$$

mit

$\omega$ = Gradientenfrequenz,

$\hat{J}_x$ = Scheitelwert der Stomamplitude im Meßbereich t2,

$\alpha$ = R/(2L) mit R = Gesamtheit aller Widerstände im Resonanzkreis,

$\omega_1$ = $[1/(LC)-\alpha^2]^{1/2}$ = Resonanzfrequenz, $q_0$, a, b = Rechenfaktoren, verknüpft über Gleichungen

1) $q_0 - \alpha a + \omega_1 b = 0$ für $J(t_0) = 0$

2)

$$\int_{t_0}^{t_1} J(t)\, dt = 0$$

3) $J(t_2) = \hat{J}_x$

und

$t'$ = $t - t_0$.

7. Verfahren nach Anspruch 5, **gekennzeichnet** durch trapezförmige Vorpulse solcher Länge und Amplitude für den Schichtselektionsgradienten $G_z$ vor dem Meßbereich $\tau_2$, daß sein Zeitintegral null ist.

8. Verfahren nach Anspruch 5, **gekennzeichnet** durch trapezförmige Vor- und Nachpulse solcher Länge und Amplitude für den Phasenkodiergradienten $G_y$ vor bzw. nach dem Meßbereich $\tau_2$, daß sein Zeitintegral null ist.

9. Verfahren nach Anspruch 5, **gekennzeichnet** durch einen Ausschwingvorgang des Auslesegradienten $G_x$ in einem Ausschwingbereich $\tau_3$ ($t_4$ bis $t_5$), der in umgekehrtem zeitlichen Verlauf wie der Einschwingvorgang im Einschwingbereich $\tau_1$ ($t_0$ bis $t_2$) verläuft, so daß das Zeitintegral über den Ausschwingvorgang des Ausschwingbereichs $\tau_3$ null wird.

## Claims

1. A nuclear magnetic resonance imaging apparatus for producing tomograms by the EPI (echo planar) method and comprising gradient coils, at least one of which is associated with a capacitor having a capacitance C and co-operating with the inductance L of the gradient coil to form a series resonant circuit which is connected to an amplifier controlled in accordance with a predetermined time function $I_v$ (t), characterised by the following features:

a) means are provided for controlling the current (I) via the gradient coil (10) comprising the at least one capacitor (12; 13, 14) so that:
   - in a measurement range $\tau_2$ ($t_2$ to $t_4$) the read-out gradient $G_x$ has a cosine curve and
   - in a build-up range $\tau_1$ ($t_0$ to $t_2$) directly preceding the measurement range ($\tau_2$), and also at the beginning of the measurement range, the gradient current (I) is steady, and at the end ($t_2$) of the build-up range $\tau_1$ the wave number $k_x$ given by the time integral of the read-out gradient $G_x$ is equal to zero and

b) the amplifier connected to the resonant circuit is a controlled-gain amplifier (20) operated as a current regulator and associated with the means listed in feature a).

2. Apparatus according to claim 1, characterised in that the capacitance C of the capacitor (12) is divided into two component capacitances (2C) of two capacitors (13, 14) disposed symmetrically relatively to the gradient coil (10).

3. Apparatus according to claim 2, characterised in that the component capacitances are each connected in parallel with a respective choke (15, 16).

4. Apparatus according to claim 1, characterised in that the controlled-gain amplifier is a switched controlled-gain amplifier.

5. A method of operating apparatus according to claim 1, characterised by current-controlled operation of the resonant circuit such that the cosine-like curve of the read-out gradient $G_x$ in the measuring range $\tau_2$ ($t_2$ to $t_4$) is preceded by a controlled build-up range $\tau_1$ ($t_0$ to $t_2$) in which the gradient current (I) is steady and at the end ($t_2$) of which the wave number $k_x$ is zero.

6. A method according to claim 5, characterised by control at the input (21) of the controlled-gain amplifier (20) such that the current curve in the build-up range $\tau_1$ ($t_0$ to $t_2$) is given by

$$J (t_0 \leq t \leq t_2) = \omega_1^{-1} \hat{J}_x \{q_0 \cos \omega t' + a \omega \sin \omega t'$$
$$+ e^{-\alpha t'} [ a(-\alpha \cos \omega_1 t' - \omega_1 \sin \omega_1 t'$$
$$+ b (\alpha \sin \omega_1 t' + \omega_1 \cos \omega_1 t']\}$$

with

| | |
|---|---|
| $\omega$ | = gradient frequency |
| $\hat{J}_x$ | = peak value of the current amplitude in the measurement range $\tau_2$ |
| $\alpha$ | = R/(2L) where R = the total of all resistances in the resonant circuit |
| $\omega_1$ | = $[1/(Lc)-\alpha^2]^{1/2}$ = resonance frequency, |
| $q_0, a, b$ | = computing factors linked by equations |

(1) $q_0 - \alpha a + \omega_1 b = 0$ for $J(t_0) = 0$ .

(2)

$$\int_{t_0}^{t_2} J(t)\, dt = 0$$

(3) $J(t_2) = \hat{J}_x$

and

$t'$ = $t - t_0$.

7. A method according to claim 5, characterised by trapezoidal pre-pulses having a length and amplitude for the slice selection gradient $G_z$ before the measuring range $\tau_2$ such that its time integral is zero.

8. A method according to claim 5, characterised by trapezoidal pre-pulses and after-pulses having a length and amplitude for the phase coding gradient $G_y$ before and after the measuring range $\tau_2$ such that its time integral is zero.

9. A method according to claim 5, characterised by a decay process of the read-out gradient $G_x$ in a decay range $\tau_3$ ($t_4$ to $t_5$) having the opposite time curve to the transient process in the build-up range $\tau_1$ ($t_0$ to $t_2$), so that the integral over the time of the decay process in the decay range $\tau_3$ is zero.

**Revendications**

1. Agencement pour la production d'images en tranches par un tomographe à spin nucléaire selon le procédé EPI (Echo-Planar-Imaging), agencement comportant des bobines à gradient dont l'une a au moins un condensateur de capacité C qui lui est conjugué, formant avec l'inductivité L de la bobine à gradient un circuit résonnant en série qui est relié à un amplificateur commandé par une fonction de temps $I_v(t)$ prédéterminée, caractérisé par les caractéristiques suivantes:
    a) Des moyens sont prévus, lesquels conduisent le courant (I) à travers la bobine à gradient (10) et le condensateur, un au minimum, (12 ; 13, 14) qui lui est associé, de manière à ce que
        - le gradient de lecture $G_x$ présente, dans une étendue de mesure $\tau_2$ ($t_2$ à $t_4$), l'allure d'une courbe cosinusoïdale et que,
        - dans une période tansitoire de rétablissement $\tau_1$ ($t_0$ to $t_2$) précédant immédiatement l'étendue de mesure $\tau_2$ , le courant de gradient (I) soit continu, le nombre d'ondes $k_x$ donné par l'intégrale de temps du gradient de lecture G étant justement nul à la fin ($t_2$) de la période transitoire de rétablissement $\tau_1$ ;

b) L'amplificateur relié au circuit résonnant est un amplificateur de réglage (20) ajdoint aux moyens décrits dans le paragraphe de la caractéristique a) et qui fonctionnne comme un régulateur de courant.

2. Agencement selon la revendication 1, caractérisé en ce que la capacité C du condensateur (12) est partagée en deux capacités partielles 2C de deux condensateurs (13, 14) situés de manière symétrique par rapport à la bobine à gradient (10).

3. Agencement selon la revendication 2, caractérisé en ce qu'une bobine de self (15 ou 16) est montée en parallèle à chacune des capacités partielles.

4. Agencement selon la revendication 1, caractérisé en ce qu'un amplificateur de réglage de commutation est prévu en tant qu'amplificateur de réglage.

5. Procédé pour le fonctionnement d'un agencement selon la revendication 1, caractérisé en ce que le fonctionnement du circuit résonnant est réglé par le courant de manière à ce qu'une période transitoire de rétablissement $\tau_1$ ($t_0$ à $t_2$) contraint - dans lequel le courant de gradient (I) soit continu et à la fin ($t_2$) duquel le nombre d'ondes $k_x$ soit nul - soit situé en amont du tracé cosinusoïdal du gradient de lecture $G_x$ dans l'étendue de mesure $\tau_2$ ($t_2$ à $t_4$).

6. Procédé selon la revendication 5, caractérisé en ce qu'une commande est prévue à l'entrée (21) de l'amplificateur de réglage (20) de manière à ce que la caractéristique du courant dans la période transitoire de rétablissement $\tau_1$ ($t_0$ à $t_2$) soit donnée par

$$J\ (t_0 \leq t \leq t_2) = \omega_1^{-1}\ \hat{J}_x\ \{q_0\ \cos \omega t' + a\ \omega\ \sin \omega t'$$
$$+\ e^{-\alpha t'}\ [\ a(-\ \alpha\ \cos\ \omega_1 t' - \omega_1\ \sin\ \omega_1 t'$$
$$+\ \ \ \ \ \ \ \ b\ (\ \alpha\ \sin\ \omega_1 t' +\ \omega_1\ \cos\ \omega_1 t'\ ]\}$$

avec

$\omega$ = fréquence de gradient,

$\hat{J}_x$ = valeur de crête de l'amplitude du courant dans l'étendue de mesure $\tau_2$,

$\alpha$ = R/(2L) avec R = totalité de toutes les résistances dans le circuit résonnant,

$\omega_1$ = $[1/(LC)-\alpha^2]^{1/2}$ = fréquence de résonance,

$q_0$, a, b = paramètres de calcul liés par les équations

  1) $q_0 - \alpha a + \omega_1 b = 0$ pour $J(t_0) = 0$

  2) $t_0 \int^{t_2} J(t) dt = 0$

  3) $J(t_2) = \hat{J}_x$

      et

$t'$ = $t - t_0$ .

7. Procédé selon la revendication 5, caractérisé par des impulsions trapézoïdales précédant l'étendue de mesure $\tau_2$ qui ont, pour le gradient $G_z$ de sélection de tranche avant $\tau_2$, une longueur et une amplitude telles que l'intégrale de temps soit nulle.

8. Procédé selon la revendication 5, caractérisé par des impulsions trapézoïdales précédant et succédant l'étendue de mesure $\tau_2$ qui ont, pour le gradient $G_y$ de codage par modulation de phase avant et après $\tau_2$, une longueur et une amplitude telles que l'intégrale de temps soit nulle.

9. Procédé selon la revendication 5, caractérisé par un transitoire de sortie du gradient de lecture $G_x$ dans une période transitoire d'évanouissement $\tau_3$ ($t_4$ à $t_5$) dont l'allure dans le temps est l'inverse de celle du transitoire d'entrée dans la période transitoire de rétablissement $\tau_1$ ($t_0$ à $t_2$), de sorte que l'intégrale dans le temps devient nulle en passant par le transitoire de sortie de la période transitoire d'évanouissement $\tau_3$.

FIG 1

FIG 2

FIG 3

EP 0 389 666 B1

FIG 4

FIG 5

FIG 6

FIG 7

14

FIG 8

FIG 9

FIG 10

EP 0 389 666 B1

FIG 11